# EUROPÄISCHE PATENTSCHRIFT

(11) **EP 1 217 651 B1**
(45) Veröffentlichungstag und Bekanntmachung des Hinweises auf die Patenterteilung: **01.09.2004**
(21) Anmeldenummer: 01128487.4
(22) Anmeldetag: 07.12.2001
(51) Int. Cl.: H01L 21/321, C09K 3/14, C09G 1/02, H01L 21/306

(54) **Saure Poliersuspension für das chemisch-mechanische Polieren von SiO2-Isolationsschichten**
Acid polishing slurry for the chemical mechanical polishing of SiO2-isolation layers
Suspension de polissage chimiomécanique acide pour le polissage des couches de SiO2 isolantes

(30) Priorität: 20.12.2000 DE 10063491
(43) Veröffentlichungstag der Anmeldung: 26.06.2002
(73) Patentinhaber: BAYER AG, 51368 Leverkusen (DE)
(72) Erfinder: Vogt, Kristina, Dr., 51061 Köln (DE); Puppe, Lothar, Dr., 51399 Burscheid (DE); Min, Chun-Kuo, Tucheng, Taipei (TW); Chen, Li-Mei, Dr., Hsinchu (TW)

(56) Entgegenhaltungen:
- EP-A- 1 077 241
- WO-A-01/78116
- WO-A-99/67056
- US-A- 6 083 840

## Beschreibung

Die vorliegende Erfindung betrifft eine saure Polierslurry für das chemisch-mechanische Polieren von SiO₂-Isolationsschichten nach der STI-Technik (STI = shallow trench isolation) und insbesondere eine kolloidale Polierslurry vom Siliciumdioxid-Typ, die ein Fluoridsalz enthält.

Gegenwärtig ist das chemisch-mechanische Polieren (CMP) bei der Herstellung von integrierten Schaltungen (Integrated Circuits, IC) eine bevorzugte Methode zur Erreichung einer optimalen Planarisierung auf Wafern (global planarization). Ein Wafer ist eine polierte Siliciumscheibe, auf der integrierte Schaltungen aufgebaut werden. Zunächst wird eine Polierslurry auf ein elastomeres Poliertuch (pad) oder direkt auf die zu polierende Wafer-Oberfläche aufgetragen. Das Poliertuch wird dann gegen die zu polierende Oberfläche gepresst und dabei relativ zur Waferebene bewegt, so dass die Partikel der Polierslurry gegen die Wafer-Oberfläche gedrückt werden. Die Bewegung des Poliertuchs bewirkt eine Verteilung der Polierslurry und damit der Partikel auf der Wafer-Oberfläche, was zu einem chemischen und mechanischen Abtrag der Substratoberfläche führt.

Die Polierslurries können in zwei Typen unterteilt werden. Der eine Typ besteht aus einer Aufschlämmung von pyrogener Kieselsäure als Schleifmittel (Abrasiv) und der andere Typ enthält kolloidales Siliciumdioxid als Schleifmittel. Die Verfahren zur Herstellung der Polierslurries aus pyrogener Kieselsäure und aus kolloidalem Siliciumdioxid, auch Kieselsol genannt, sind verschieden. Die Aufschlämmung von pyrogener Kieselsäure wird erhalten, indem pyrogene Kieselsäure in einem wässrigen Medium dispergiert wird. Für Polierslurries, die kolloidales Siliciumdioxid enthalten, wird das kolloidale Siliciumdioxid mittels der Sol-Gel-Technik direkt aus einer wässrigen Lösung, z. B. aus einer Natriumsilikatlösung, gewonnen. Zu keinem Zeitpunkt der Herstellung liegt das kolloidale Siliciumdioxid in einem getrockneten Zustand vor, der zur Agglomeration oder Aggregation führen kann, wie es bei der pyrogenen Kieselsäure der Fall ist. Die Aufschlämmung von pyrogener Kieselsäure hat eine breitere Teilchengrößenverteilung als die Polierslurry vom Typ des kolloidalen Siliciumdioxids. Dies führt dazu, dass die Teilchen der Polierslurry aus pyrogener Kieselsäure während der Lagerung und/oder dem Polieren agglomerieren oder sedimentieren, was zusätzlich zu einer ungleichmäßigen Teilchengrößen-Verteilung führt. Somit werden beim Einsatz der Polierslurry aus pyrogener Kieselsäure Defekte wie Oberflächen-Rauhigkeit und Mikrokratzer auf der polierten Halbleiter-Oberfläche verursacht. Ein solches Phänomen wird schwerwiegender, wenn die Linienbreite des IC-Bauelements auf 0,25 µm bzw. 0,18 µm oder darunter abnimmt. Daher findet die Polierslurry vom Typ des kolloidalen Siliciumdioxids eine zunehmende Verbreitung.

Bei der integrierten Halbleitertechnik müssen gewöhnlich mehrere aktive und passive Elemente innerhalb der integrierten Schaltkreisstruktur voneinander isoliert werden. Dies wird oft mittels der STI-Technik bewerkstelligt, die die Probleme der beim LOCOS-Verfahren auftretenden Feld-Oxid-Diffusion und der mechanischen Beanspruchung lösen kann. Sie weist Vorteile auf, wie eine gute Isolierwirkung und die Erhöhung der Integrationsdichte und Planarisierung des IC-Bauelements. Daher wurde STI die Haupt-Isolationstechnik bei der 0,18-µm-CMOS-Technologie.

Die STI-Technik umfasst die Erzeugung eines schmalen Grabens im Silicium, dem Ausfüllen des schmalen Grabens mit Siliciumdioxid (SiO₂), wobei auch gleichzeitig die gesamte Waferoberfläche mit einem Siliciumdioxid-Film überzogen wird, gefolgt von der Planarisierung durch die CMP-Technik. Es ist üblich, vorher einen härteren Siliciumnitrid(Si₃N₄)-Film unter dem zu polierenden Siliciumdioxid-Film auszubilden, so dass der Siliciumnitrid-Film während des Polierens als Stopper-Schicht dient. Eine ideale, für den Gebrauch gut geeignete Polierslurry ist einerseits dazu fähig, den Siliciumdioxid-Film oberhalb des schmalen Grabens wirksam zu polieren ohne andererseits den Siliciumnitrid-Film abzupolieren. Das heißt, dass eine Polierslurry erwünscht ist, bei der die Geschwindigkeit für das Polieren des Siliciumdioxid-Films so hoch wie möglich ist und die Geschwindigkeit für das Polieren des Siliciumnitrid-Films nahezu null ist.

Ein gewöhnlich verwendeter Index zur Auswertung der Geschwindigkeit des Polierens von Siliciumdioxid auf Siliciumnitrid ist die Polierselektivität, die dadurch definiert wird, dass die Poliergeschwindigkeit von Siliciumdioxid durch die Poliergeschwindigkeit von Siliciumnitrid dividiert wird. Wenn eine Polierslurry mit einer niedrigen SiO₂/Si₃N₄-Selektivität zum Polieren des SiO₂ verwendet wird, das sich oberhalb eines Grabens befindet, treten ein sog. "dishing" des SiO₂ und eine sog. "erosion" des Si₃N₄ auf.

Bei der gegenwärtigen IC-Fabrikation ist die Selektivität der eingesetzten CMP-Polierslurries nicht ausreichend hoch genug. Daher verkürzt man die Polierdauer und verwendet zur Vermeidung des Problems des sog. "dishing" des SiO₂ die Technik des reaktiven Ionenätzens (RIE-Technik). Dieses kombinierte RIE + CMP-Verfahren verlängert jedoch die gesamte Herstellungsdauer um etwa 40 % und führt daher zu einer Erhöhung der Herstellungskosten.

Eine normalerweise verwendete Methode zur Erhöhung der Polierselektivität einer Polierslurry aus pyrogener Kieselsäure besteht in der Zugabe von Natriumhydroxid oder Kaliumhydroxid in hoher Konzentration, um den pH-Wert bei 22°C auf über 12,5 zu erhöhen. Auf der polierten Halbleiter-Oberfläche tritt dann jedoch Lochfraß auf.

Verschiedene Polierslurries wurden entwickelt, um die Polierselektivität bezüglich der Geschwindigkeit der Entfernung von Siliciumdioxid gegenüber Siliciumnitrid zu erhöhen. In US-A 4 526 631 ergibt eine Polierslurry mit 6 Gew.-% kolloidalem Siliciumdioxid, die mit KOH auf einen pH-Wert bei 22°C von etwa 12 eingestellt ist, ein Polierverhältnis von etwa 10 SiO₂ zu 1 Si₃N₄. In US-A 5 738 800 enthält die Polierzusammensetzung zum Polieren einer Kombination aus Siliciumdioxid und Siliciumnitrid eine aromatische Verbindung, die mit Siliciumdioxid und Siliciumnitrid Komplexe bildet. In US-A 5 759 917 umfasst die Zusammensetzung Ammoniumcernitrat, Essigsäure und pyrogene Kieselsäure. In US-A 5 733 819 umfasst die Polierzusammensetzung feines Siliciumnitrid-Pulver, Wasser und eine Säure. In EP-A 853 335 enthält die Zusammensetzung pyrogene Kieselsäure als Abrasiv, ein Tetramethylammonium-Salz und Wasserstoffperoxid. EP-A 853 110 macht eine alkalisierte Polierslurry zur Verbesserung der Polierselektivität verfügbar, die ein Fluoridsalz enthält. In EP-A 1 077 241 wird eine Zusammensetzung aus einen Siliziumdioxidabrasiv, einem Suspensionsmedium, einer Peroxyverbindung, einer fluoridhaltigen Verbindung als ätzendem Agenz und einem Alkylammoniumhydroxid beschrieben, wobei dem Alkylammoniumhydroxid eine Erhöhung der Polierselektivität bezüglich der Geschwindigkeit der Entfernung von Siliciumdioxid gegenüber Siliciumnitrid zugeschrieben wird. Jedoch fehlen in EP-A 1 077 241 sowohl Polierversuche als auch jegliche Angabe expliziter Selektivitätsangaben. Weitere Polierslurries enthaltend fluoridhaltige Verbindungen, wurden bereits in der Literatur beschrieben. Diese werden jedoch zum Polieren von Kupfer- oder Tantaloberflächen eingesetzt und enthalten entsprechend zusätzlich zum Siliziumdioxidabrasiv und der fluoridhaltigen Verbindung weitere erforderliche Komponenten wie organische Säuren und Oxidationmittel.

Daher besteht die Aufgabe der vorliegenden Erfindung in der Lösung der oben erwähnten Probleme und in der Bereitstellung einer sauren, kolloidalen Polierslurry vom Siliciumdioxid-Typ für das chemisch-mechanische Polieren mit einer hohen Polierselektivität bezüglich der Geschwindigkeit der Abtragung von Siliciumdioxid gegenüber Siliciumnitrid.

Um die oben erwähnte Aufgabe zu lösen, enthält die saure Polierslurry der vorliegenden Erfindung folgende Komponenten:
0,1 bis 5 Gew.-% eines kolloidalen Siliciumdioxid-Abrasivs und
0,5 bis 10 Gew.-% eines Fluoridsalzes.

Die saure Polierslurry der vorliegenden Erfindung ist für das chemisch-mechanische Polieren von SiO₂-Isolationsschichten nach der STI-Technik besonders geeignet. Bevorzugt wird die Polierslurry zum Polieren einer Kombination verwendet, die Siliciumdioxid und Siliciumnitrid enthält. Besonders bevorzugt wird die Polierslurry zum Polieren eines dielektrischen Films wie z. B. eines Siliciumdioxid-Films verwendet, der auf einem Siliciumnitrid-Film ausgebildet ist, wobei der Siliciumnitrid-Film als Stopper verwendet wird.

In der Polierslurry der vorliegenden Erfindung ist das kolloidale Siliciumdioxid-Abrasiv vorzugsweise in einer Menge von 0,1 bis 3,5 Gew.-% vorhanden, und das Fluoridsalz ist in einer Menge von 1 bis 6 Gew.-% vorhanden. Das kolloidale Silici umdioxid kann eine mittlere Teilchengröße von 10 nm bis 1 µm, vorzugsweise 20 nm bis 100 nm aufweisen.

Die mittlere Teilchengröße wird mittels Sedimentation im Schwerefeld in einer Ultrazentrifuge bestimmt.

Das in der vorliegenden Erfindung verwendete Fluoridsalz kann ein Ammoniumsalz sein. Besonders geeignet sind Ammoniumfluorid und Ammoniumhydrogenfluorid. Das Fluoridsalz kann eine starke Bindung mit Siliciumdioxid ausbilden und die Siliciumnitrid-Oberfläche in einen hydrophoben Zustand überführen, wodurch die Hydrolyse von Siliciumnitrid gehemmt wird. Auf diese Weise wird die Polierselektivität bezüglich der Geschwindigkeit des Entfernens von Siliciumdioxid gegenüber Siliciumnitrid erhöht.

Die Polierslurry der vorliegenden Erfindung kann weiterhin eine anorganische Säure enthalten, die zur Einstellung des pH-Werts der Polierslurry verwendet wird. Der pH-Wert bei 22°C der Polierslurry der vorliegenden Erfindung beträgt vorzugsweise 2 bis 6.

Die Selektivität der Polierslurry der vorliegenden Erfindung kann bis auf 12 erhöht werden; daher ist zur Bewerkstelligung der Planarisierung keine zusätzliche Technik wie RIE erforderlich. Somit kann die Gesamtherstellungsdauer verkürzt werden, und Herstellungskosten können eingespart werden.

Die Polierslurry der vorliegenden Erfindung ist sauer. Daher können die bei der basischen Polierslurry auftretenden Probleme, wie z. B. Lochfraß, auf der polierten Halbleiter-Oberfläche vermieden werden.

Die nachfolgenden Beispiele sollen das Verfahren und die Vorteile der vorliegenden Erfindung ausführlicher veranschaulichen, ohne deren Rahmen einzuschränken.

### Beispiele

Die Polierslurries der Beispiele und Vergleichsbeispiele wurden gemäß den untenstehenden Angaben hergestellt. Mit den Polierslurries wurden Filme auf Silicium-Wafern mittels einer Westech-372-Poliermaschine poliert, die entweder aus Niederdruck-CVD-Siliciumdioxid (SiO₂) oder aus Niederdruck-CVD-Siliciumnitrid (Si₃N₄) bestanden. Die Ergebnisse sind in Tabelle 1 angegeben. Die Poliergeschwindigkeit wird aus der Division der Differenzdicke vor und nach dem Polieren durch die Polierdauer berechnet, wobei die Filmdicke durch Nanospec gemessen wird. Die Polierselektivität wird durch Division der Poliergeschwindigkeit von Siliciumdioxid durch die Poliergeschwindigkeit von Siliciumnitrid berechnet.

### Beispiel 1

Levasil® 50 CK / 30 % - V1, ein von Bayer AG, Leverkusen bezogenes kolloidales Kieselsol, wurde mit entionisiertem Wasser verdünnt, wobei eine Polierslurry mit 2 Gew.-% kolloidalem Siliciumdioxid erhalten wurde. Die mittlere Teilchengröße des kolloidalen Siliciumdioxids beträgt 60 bis 90 nm und die spezifische Oberfläche liegt bei 50 bis 180 m²/g. 4 Gew.-% Ammoniumhydrogenfluorid wurden zu der verdünnten Polierslurry gegeben und gründlich vermischt. Zur Einstellung des pH-Werts auf 3,8 wurde eine anorganische Säure zur Mischung gegeben, wodurch die erwünschte Polierslurry erhalten wurde. Die Ergebnisse sind in Tabelle 1 angegeben.

### Beispiel 2

Dieselben Verfahren wie in Beispiel 1 wurden angewandt mit der Ausnahme, dass der pH-Wert der Polierslurry auf 5 eingestellt wurde. Die Ergebnisse sind in Tabelle 1 dargestellt.

### Beispiel 3

Dieselben Verfahren wie in Beispiel 1 wurden angewandt mit der Ausnahme, dass Ammoniumhydrogenfluorid in einer Menge von 1 Gew.-% zugegeben wurde. Darüber hinaus wurde der pH-Wert der Polierslurry auf 3,8 eingestellt. Die Ergebnisse sind in Tabelle 1 dargestellt.

### Beispiel 4

Dieselben Verfahren wie in Beispiel 1 wurden angewandt mit der Ausnahme, dass Ammoniumhydrogenfluorid in einer Menge von 1 Gew.-% zugegeben und der pH-Wert der Polierslurry auf 5 eingestellt wurde. Die Ergebnisse sind in Tabelle 1 dargestellt.

### Vergleichsbeispiel 1

SS 25®, eine von Cabot Microelectronics, Aurora, I11., USA bezogene Polierslurry mit pyrogener Kieselsäure, wurde mit entionisiertem Wasser verdünnt, wodurch eine Polierslurry mit 2 Gew.-% Siliciumdioxid erhalten wurde. Der pH-Wert der Polierslurry lag bei 11,2. Die Ergebnisse sind in Tabelle 1 dargestellt.

Aus den obigen Beispielen geht hervor, dass die Polierslurry vom Typ des kolloidalen Siliciumdioxids infolge der Zugabe eines Fluoridsalzes eine viel höhere Polierselektivität bezüglich der Geschwindigkeit des Entfernens von Siliciumdioxid gegenüber Siliciumnitrid als eine herkömmliche Polierslurry aus pyrogener Kieselsäure aufweist.

Die zuvor aufgeführte Beschreibung der bevorzugten Ausführungsformen dieser Erfindung wurde aus Gründen der Veranschaulichung und der Beschreibung angegeben.

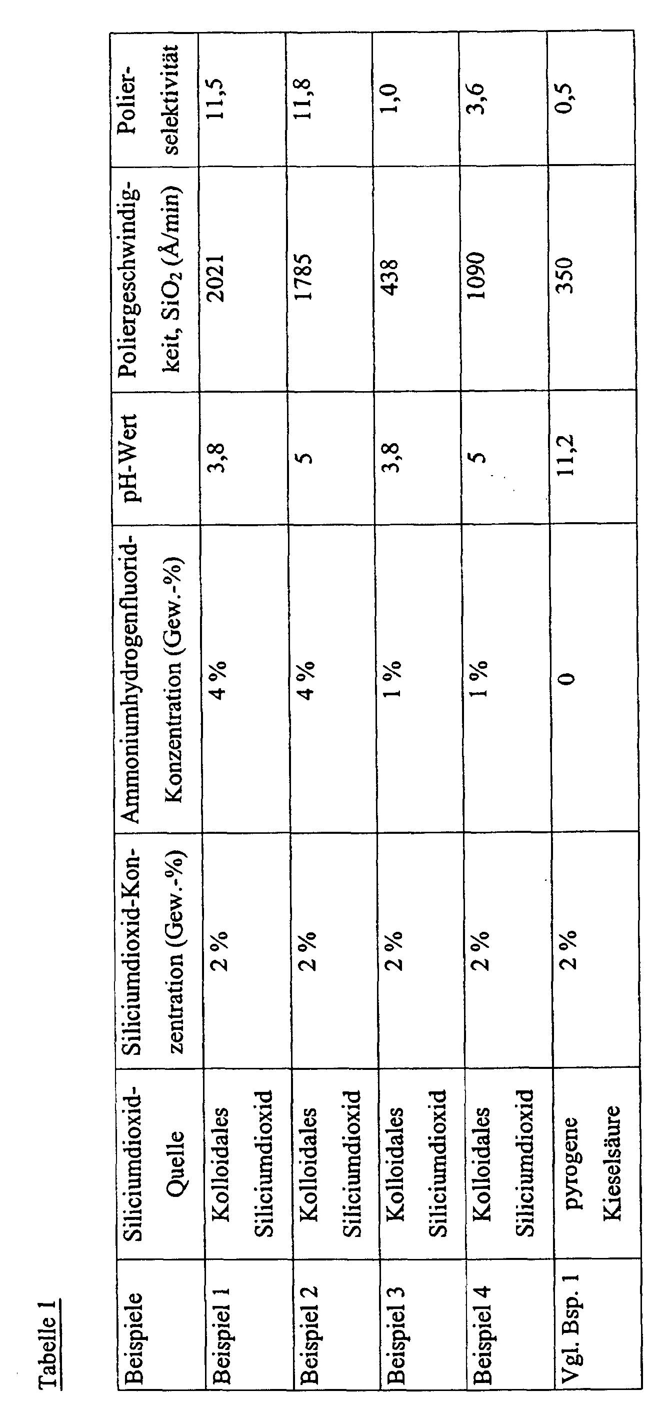

## Patentansprüche

1. Verfahren zum chemisch-mechanischen Polieren, **dadurch gekennzeichnet, dass** eine SiO₂-Isolationsschicht oder ein Verbundstoff, der Siliciumdioxid und Siliciumnitrid enthält, mit einer sauren Polierslurry enthaltend
0,1 bis 5 Gew.-% eines kolloidalen Siliciumdioxid-Abrasivs und
0,5 bis 10 Gew.-% eines Fluoridsalzes
poliert wird.

2. Verfahren nach Anspruch 1, **dadurch gekennzeichnet, dass** das kolloidale Siliciumdioxid-Abrasiv in einer Menge von 0,1 bis 3,5 Gew.-% und das Fluoridsalz in einer Menge von 1 bis 6 Gew.-% vorliegt.

3. Verfahren nach Anspruch 1, **dadurch gekennzeichnet, dass** das Fluoridsalz ein Ammoniumsalz ist.

4. Verfahren nach Anspruch 3, **dadurch gekennzeichnet, dass** das Fluoridsalz Ammoniumfluorid oder Ammoniumhydrogenfluorid ist.

5. Verfahren nach Anspruch 4, **dadurch gekennzeichnet, dass** das Fluoridsalz Ammoniumhydrogenfluorid ist.

6. Verfahren nach Anspruch 1, **dadurch gekennzeichnet, dass** die Polierslurry einen pH-Wert bei 22°C von 2 bis 6 aufweist.

7. Verfahren nach Anspruch 1, **dadurch gekennzeichnet, dass** das kolloidale Siliciumdioxid eine mittlere Teilchengröße von 10 nm bis 1 µm aufweist.

8. Verfahren nach Anspruch 7, **dadurch gekennzeichnet, dass** das kolloidale Siliciumdioxid eine mittlere Teilchengröße von 20 nm bis 100 nm aufweist.

9. Verfahren nach Anspruch 1, **dadurch gekennzeichnet, dass** der Verbundstoff, der Siliciumdioxid und Siliciumnitrid enthält, ein dielektrischer Siliciumdioxid-Film ist, der auf einem Siliciumnitrid-Film ausgebildet ist.

10. Verfahren nach Anspruch 1, **dadurch gekennzeichnet, dass** die Polierselektivität bezüglich der Geschwindigkeit des Entfernens von Siliciumdioxid gegenüber Siliciumnitrid eine Selektivität von 3,6 bis 12 ist.

## Claims

1. Method for chemical-mechanical polishing, **characterized in that** an SiO₂ isolation layer or a composite material which contains silica and silicon nitride is polished with an acidic polishing slurry containing:
0.1 to 5% by weight of a colloidal silica abrasive, and
0.5 to 10% by weight of a fluoride salt.

2. Method according to Claim 1, **characterized in that** the colloidal silica abrasive is present in a quantity of from 0.1 to 3.5% by weight and the fluoride salt is present in a quantity of from 1 to 6% by weight.

3. Method according to Claim 1, **characterized in that** the fluoride salt is an ammonium salt.

4. Method according to Claim 3, **characterized in that** the fluoride salt is ammonium fluoride or ammonium hydrogen fluoride.

5. Method according to Claim 4, **characterized in that** the fluoride salt is ammonium hydrogen fluoride.

6. Method according to Claim 1, **characterized in that** the polishing slurry has a pH of from 2 to 6 at 22°C.

7. Method according to Claim 1, **characterized in that** the colloidal silica has a mean particle size of from 10 nm to 1 µm.

8. Method according to Claim 7, **characterized in that** the colloidal silica has a mean particle size of from 20 nm to 100 nm.

9. Method according to Claim 1, **characterized in that** the composite material which contains silica and silicon nitride is a dielectric silica film which is formed on a silicon nitride film.

10. Method according to Claim 1, **characterized in that** the polishing selectivity in terms of the rate of removal of silica compared to silicon nitride has a selectivity of from 3.6 to 12.

## Revendications

1. Procédé pour le polissage chimique-mécanique, **caractérisé en ce que** l'on polit une couche isolante de SiO₂ ou une matière composite contenant de la silice et du nitrure de silicium par une bouillie de polissage acide contenant :
0,1 à 5 % en poids d'une silice colloïdale constituant l'abrasif et
0,5 à 10 % en poids d'un sel de l'acide fluorhydrique

2. Procédé selon la revendication 1, **caractérisé en ce que** la silice colloïdale constituant l'abrasif est présente en quantité de 0,1 à 3,5 % en poids et le sel de l'acide fluorhydrique en quantité de 1 à 6 % en poids.

3. Procédé selon la revendication 1, **caractérisé en ce que** le sel de l'acide fluorhydrique est un sel d'ammonium.

4. Procédé selon la revendication 3, **caractérisé en ce que** le sel de l'acide fluorhydrique est le fluorure d'ammonium ou le bifluorure d'ammonium.

5. Procédé selon la revendication 4, **caractérisé en ce que** le sel de l'acide fluorhydrique est le bifluorure d'ammonium.

6. Procédé selon la revendication 1, **caractérisé en ce que** la bouillie de polissage a un pH de 2 à 6 à 22°C.

7. Procédé selon la revendication 1, **caractérisé en ce que** la silice colloïdale a une dimension de particule moyenne de 10 nm à 1 µm.

8. Procédé selon la revendication 7, **caractérisé en ce que** la silice colloïdale a une dimension de particule moyenne de 20 nm à 100 nm.

9. Procédé selon la revendication 1, **caractérisé en ce que** la matière composite contenant de la silice et du nitrure de silicium est une pellicule diélectrique de silice formée sur une pellicule de nitrure de silicium.

10. Procédé selon la revendication 1, **caractérisé en ce que** la sélectivité de polissage, à savoir le rapport de la vitesse d'élimination de la silice à la vitesse d'élimination du nitrure de silicium, est de 3,6 à 12.
